# EUROPEAN PATENT SPECIFICATION

(11) **EP 2 657 957 B1**
(45) Date of publication and mention of the grant of the patent: **11.03.2020**
(21) Application number: 11849995.3
(22) Date of filing: 21.12.2011
(51) Int. Cl.: C23C 16/448, C23C 16/455, B01D 1/00

(54) **VAPORIZER**
VERDAMPFER
VAPORISEUR

(30) Priority: 21.12.2010 JP 2010284916
(43) Date of publication of application: 30.10.2013
(73) Proprietor: Kabushiki Kaisha Watanabe Shoko, Tokyo 103-0022 (JP); Kusuhara, Masaki, Tokyo 103-0022 (JP); Umeda, Masaru, Tokyo 103-0022 (JP); Toda, Masayuki, Nihonmatsu-shi, Fukushima 964-0904 (JP)
(72) Inventor: KUSUHARA, Masaki, Tokyo 103-0022 (JP); UMEDA, Masaru, Tokyo 103-0022 (JP); TODA Masayuki, Nihonmatsu-shi Fukushima 964-0904 (JP); FUKAGAWA, Mitsuru, Tokyo 169-0074 (JP)
(74) Representative: Dr. Weitzel & Partner
(86) International application number: PCT/JP2011/079727
(87) International publication number: WO 2012/086728

(56) References cited:
- JP-A- 10 074 746
- JP-A- 2000 119 859
- JP-A- 2001 011 634
- JP-A- 2003 213 422
- JP-A- 2008 196 054
- JP-A- 2009 054 655
- US-A1- 2009 186 479

## Description

### TECHNICAL FIELD

The present invention relates to a vaporizer that vaporizes a film forming liquid material included in a carrier gas, and to a film deposition apparatus including the vaporizer.

### BACKGROUND ART

Conventionally, such a technique is known in which in a film deposition apparatus that forms a film on the surface of a semiconductor wafer using a CVD device or the like including an MOCVD device, a carrier gas including a film forming liquid material is supplied to a vaporizer and the film forming liquid material included in the carrier gas is vaporized in the vaporizer.

Moreover, in such a vaporizer, a heater is disposed on the outer periphery of the vaporizer or disposed on the outer periphery of a pipe to supply a carrier gas into the vaporizer, and a film forming material included in a carrier gas is vaporized by the heat of the heater. See the following documents:
- JP-A-11 -186170 (D1)
- JP-A-2000-031134 (D2)
- JP-A-2003-224118 (D3)
- WO 02/058141 (D4)
- JP-A-2002-115067 (D5)
- JP 2000 119859 A (D6)
- US 2009/186479 A1 (D7).

D4 discloses a technique in which a liquid raw material is introduced into a carrier gas, the liquid raw material is formed into fine particles in the order of micron or less (one micron or less) and dispersed in the carrier gas (in the following, a carrier gas in which a liquid raw material is dispersed is referred to as a raw material gas), the raw material gas is introduced into a vaporizer and vaporized, and then a film is formed in a reaction chamber. At this time, for the purpose of preventing that only a solvent is vaporized to cause clogging at an outlet, for example, a unit that cools the outlet is provided. Moreover, in order to disperse a liquid raw material into a carrier gas in smaller particles, a preferable condition for the flow rate of the carrier gas is a flow rate ranging from 50 to 340 m/sec.

However, when a film is formed by the technique, ripples are sometimes produced on the surface of a film. Moreover, the existence of particles is recognized in a film or on a surface. Furthermore, the composition of a film is sometimes shifted from a target composition. In addition, a carbon content is sometimes increased.

Moreover, in the description of D4, in the case where an STO film is formed, for example, a liquid raw material cannot be vaporized unless the temperature is set to a temperature of 300°C or more near a coupling to another device near the outlet of the vaporizer. Namely, it is necessary to set a temperature much higher than a theoretical temperature. However, for example, in the case where a coupling is heated at a temperature of 300°C, an O-ring at the coupling is demanded to have high heat resistance, and a metal ring is inevitably used in some cases.

D5 describes a vaporizer for a liquid raw material for forming a film in which the shape of a vaporization unit is in a shape spreading on the input side of a gas and a heater is disposed in the vaporizer.

D6 discloses a vaporizer with a main body, into which a carrier gas is introduced, further comprising a heater main body disposed inside the main body; the heater main body is configured in order of an inlet portion, a peripheral portion and a discharge portion.

D7 discloses a vaporizer comprising a main body, into which a carrier gas is introduced, and a heater main body disclosed inside the vaporizer main body; a unit for cooling the inlet portion for the carrier gas is provided.

### DISCLOSURE OF THE INVENTION

### PROBLEMS THAT THE INVENTION IS TO SOLVE

In D4, for example, in the case where an STO film is formed, a liquid raw material cannot be vaporized unless the temperature is set to a temperature of 300°C or more near the coupling to another device near the outlet of the vaporizer. Namely, it is necessary to set a temperature much higher than a theoretical temperature. However, for example, in the case where the coupling is heated at a temperature of 300°C, the O-ring at the coupling is demand to have high heat resistance, causing a problem in that a metal ring is inevitably used in some cases.

In D5, since the shape of the vaporization unit is in a shape spreading on the input side of a gas, such problems arise in that a gas flow stagnates at a portion in a concave curve shape, in that a jet stream deviates due to the disturbance of an air current and it is difficult to perform sufficient vaporization, and in that attachments are accumulated on a portion in a concave curve shape to produce particles, for example.

It is an object of the present invention is to provide a vaporizer that can reduce ripples, particles, and a carbon content of a film and can supply a raw material capable of forming a film having a desired composition.

Moreover, it is an object to provide a film deposition apparatus, with the use of such a vaporizer, that can facilitate vaporization in the vaporizer and can suppress the production of ripples or the like in forming a film.

It is an object of the present invention to provide a vaporizer that can perform sufficient vaporization without heating more than necessary.

### THE INVENTION SOLVING THE PROBLEMS

The invention relates to the vaporizer of claim 1.

It is the objective of the invention to design such a vaporizer such that the working efficiency is as high as possible.

The present inventors investigated the causes of the problems in the conventional techniques by conducting various experiments. As a result, the present inventors found a cause that a liquid material dispersed in a carrier gas might be fed into a reaction chamber as the liquid material is insufficiently vaporized, and attempted to solve the problems. As a result, it was confirmed by experiment that non-vaporization is not always prevented when the heating temperature is simply increased. Moreover, an increase in the temperature adversely affects a coupling, for example.

The said objective will be achieved by the features of claim 1.

The teachings as per the subclaims are advantageous in that they assist in achieving the solution of the underlying problem.

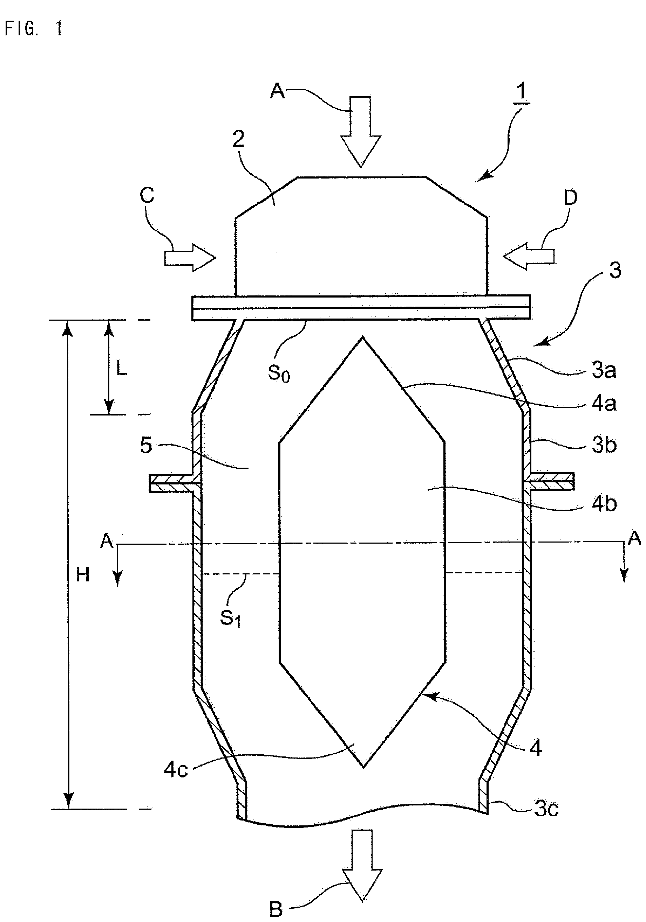

Although the length (H in Fig. 1) of the vaporizer is varied depending on the conditions of forming a film, the length generally is ranging from 5 to 100 cm, or from 10 to 50 cm. When a raw material gas is introduced at high speed, it is likely that the raw material gas immediately flows from the inlet port to the discharge port without receiving heat necessary for vaporization. Therefore, it is particularly effective in the case where the discharge portion is disposed on the extending axis of the inlet portion for the carrier gas.

For the relationship between the cross sectional area of a portion indicated by S0 in Fig. 1 and a cross sectional area S1 of a passage at a portion where an internal heater 4 is disposed, S1 is set in a range of 0.8 to 1.2 with respect to S0, preferably, S1 ranges from 0.9 to 1.1. In the case where the range is set, it was confirmed that vaporization is instantaneously performed and an unreacted liquid raw material is reduced sharply.

It is noted that as for the cross sectional area S1 of the passage, the cross sectional area of a passage at a portion where the heater exists in claim 4 is the cross sectional area of a passage around the heater in a cylindrical shape in Fig. 1. The cross sectional area of a passage around a cone at a portion where the heater exists in claim 5 is the cross sectional area of a passage around a portion where the heater is in a cone around the cone-shaped inlet portion of the heater.

Furthermore, for the internal heater, a slope portion in a cone or in a polygonal pyramid is provided on the raw material gas inlet portion side for preventing a turbulent flow. Preferably, the cross sectional area of the gas inlet portion corresponding to the slope portion is also the same as S1.

Therefore, a slope portion is formed also on the outer shape of the vaporizer along the slope portion of the internal heater. It is noted that a slope is also provided on the discharge portion side.

The carrier gas including the film forming liquid material may be introduced into the vaporizer main body at a velocity ranging from 50 m/s to 350 m/s.

In order that a liquid raw material is chopped and atomized in small particles (an outer diameter of 1 µm or less) and the particles are dispersed in a carrier gas, for preferable use, the liquid raw material is introduced into the carrier gas at a velocity of 50 m/s to 350 m/s (more particularly, at subsonic speed (0.6 to 0.75 of sonic speed). When the present invention is applied in the case under the conditions, the vaporization rate can be significantly improved.

The passage of the carrier gas, the liquid raw material, and the passage of the raw material gas to the inlet portion of the raw material gas may be cooled.

The second heater is disposed on an outer periphery on a discharge side of the vaporizer main body.

The second heater is disposed, so that a temperature difference on the vaporization passage can be further reduced.

The vaporizer according to the invention comprises a cone of the inlet portion of the heater main body, a cone height/a cone base diameter ranges from 0.5 to 1. Here, when the cone height/the cone base diameter is less than 0.5, the cone becomes flat to cause a problem in that the cone becomes a resistance to a carrier gas flow, whereas when the cone height/the cone base diameter is more than 1, the height of the cone is increased to cause a problem in that the length of the vaporizer device is increased.

At this time, the vaporizer main body includes an inlet portion formed near an inlet port for a carrier gas and expanding its opening in the discharging direction of the carrier gas, a body continued to the inlet portion, and a discharge portion shrinking its opening from the body to the discharging direction of the carrier gas, and the heater main body integrally includes an inlet portion formed near the inlet port for the carrier gas and expanding its opening in the discharging direction of the carrier gas, a body continued to the inlet portion, and a discharge portion shrinking its opening from the body to the discharging direction of the carrier gas.

Moreover, the vaporizer main body and the heater main body are configured in such a way that the locations of the inlet portion, the peripheral portion, and the discharge portion of the vaporizer main body correspond to the locations of the inlet portion, the peripheral portion, and the discharge portion of the heater main body at almost the same locations.

Furthermore, the vaporizer main body and the heater main body have a nearly perfect circle in a flat cross sectional shape intersecting with the discharging direction of the carrier gas, and the centers of the circles are coaxially disposed.

It is noted that as described above, a second heater is disposed on the outer periphery on the discharge side of the vaporizer main body.

### EFFECT OF THE INVENTION

In accordance with the vaporizer according to the invention it is possible to provide a vaporizer that can reduce ripples, particles, and a carbon content of a film and can supply a raw material capable of forming a film having a desired composition.

Further, it is possible to provide a vaporizer that can further reduce a temperature difference on a vaporization passage.

In accordance with the film deposition apparatus according to the invention, it is possible to provide a film deposition apparatus that can facilitate vaporization in the vaporizer and can suppress the production of ripples or the like in forming a film.

According to the present invention, it is possible to provide a vaporizer that can perform sufficient vaporization without heating more than necessary and can facilitate temperature management.

### BRIEF DESCRIPTION OF THE DRAWINGS

Fig. 1 is an illustration of a vaporizer according to an embodiment of the present invention;
Fig. 2 is a cross sectional view of the vaporizer according to the present invention along a line A-A in Fig. 1; and
Fig. 3 is an illustration of a vaporizer according to another embodiment of the present invention.

### DESCRIPTION OF REFERENCE NUMERALS AND SIGNS

- 1: Vaporizer
- 2: Pipe connecting unit
- 3: Vaporizer main body
- 3a: Inlet portion
- 3b: Cylindrical portion
- 3c: Discharge portion
- 4: Heater main body
- 4a: Inlet portion
- 4b: Peripheral portion
- 4c: Discharge portion
- 5: Vaporization passage
- 6: Second heater

### BEST MODE FOR CARRYING OUT THE INVENTION

Next, a vaporizer according to an embodiment of the present invention will be described with reference to the drawings.

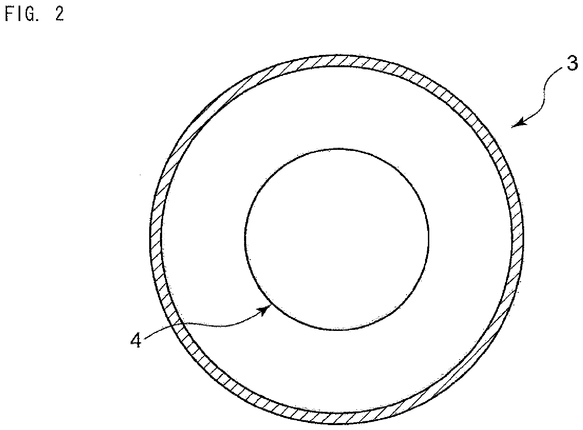

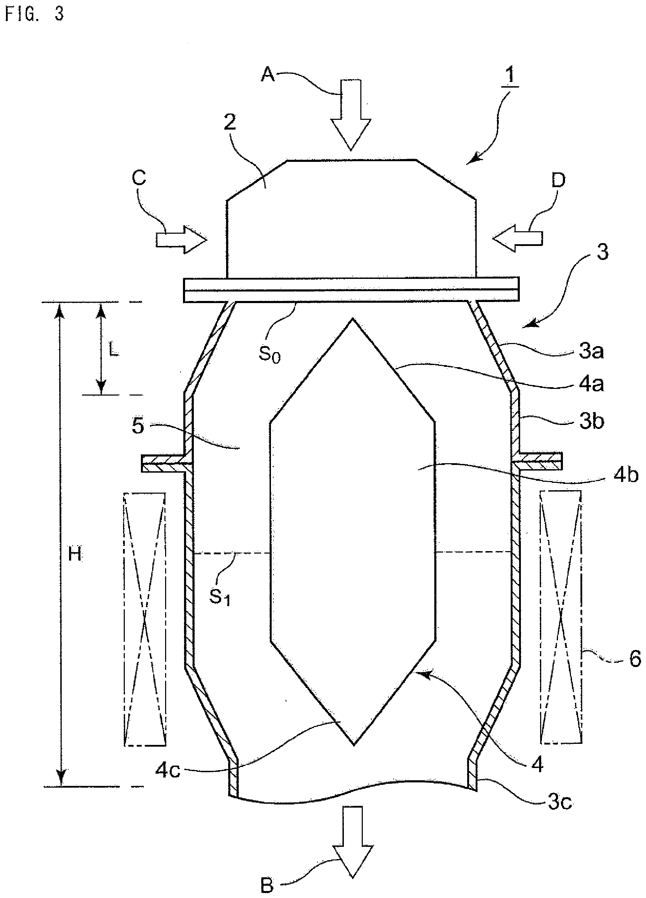

Fig. 1 is an illustration of a vaporizer according to an embodiment of the present invention, Fig. 2 is a cross sectional view of the vaporizer according to the present invention along a line A-A in Fig. 1, and Fig. 3 is an illustration of a vaporizer according to another embodiment of the present invention.

As illustrated in Fig. 1, in a vaporizer 1 according to an embodiment of the present invention, a carrier gas including a film forming liquid material is flowed from the upper part in the drawing as indicated by an arrow A, and a mist is discharged to the lower side in the drawing as indicated by an arrow B, so that a vaporized carrier gas is discharged into a most film chamber or the like.

It is noted that as illustrated in Fig. 1, a plurality of film forming liquid materials can be charged into the vaporizer 1 (see arrows C and D) or film forming liquid materials can be switched and charged into the vaporizer 1.

Moreover, the vaporizer 1 includes a pipe connecting unit 2 disposed on the upper part in the drawing to charge the carrier gas described above, a vaporizer main body 3 connected to the pipe connecting unit 2, and a heater main body 4 disposed in the vaporizer main body 3. It is noted that the lower part of the vaporizer main body 3 in the drawing is freely used according to purposes such as being connected SH to a pipe connecting unit similar to the pipe connecting unit 2 and being connected to a film deposition apparatus (a chamber).

The vaporizer main body 3 is divided into an upper part and a lower part in the drawing, and has nearly a perfect circle shape in the cross section (the horizontal cross section) as illustrated in Fig. 2. Moreover, the vaporizer main body 3 includes an inlet portion 3a expanding its opening in a cone or in a polygonal pyramid from the pipe connecting unit 2 to the lower part in the drawing, a peripheral portion (a body) 3b continued to the inlet portion 3a, and a discharge portion 3c shrinking its opening in a cone or in a polygonal pyramid to the lower part in the drawing.

The heater main body 4 is divided into an upper part and a lower part in the drawing, and has nearly a perfect circle shape in the cross section (the horizontal cross section) as illustrated in Fig. 2. Thus, the center of the vaporizer main body 3 and the center of the heater main body 4 are coaxially disposed, a vaporization passage 5 formed by the inside of the vaporizer main body 3 and the outer periphery of the heater main body 4 can be equally partitioned, and uniform vaporization can be performed. Moreover, in the vaporizer main body 3, an inlet portion 4a located on the pipe connecting unit 2 side and expanding its opening in a cone to the lower part in the drawing, a cylindrical portion (a body) 4b continued to the inlet portion 4a, and a discharge portion 4c shrinking its opening in a cone to the lower part in the drawing are integrally formed. Furthermore, the heater main body 4 may generate heat by any methods as by directly generating heat or by internally generating heat. In the heating, the heater main body 4 can directly manage the temperature in the vaporization passage 5 by setting the surface temperature of the heater main body 4 as well as the heater main body 4 can efficiently vaporize a carrier gas because the carrier gas is discharged to the lower part in the drawing while directly contacting the heater main body 4.

It is noted that in the embodiment, the heater main body 4 is configured in such a way that the inlet portion 3a of the vaporizer main body corresponds to the inlet portion 4a of the heater main body at almost the same locations, the cylindrical portion 3b of the vaporizer main body corresponds to the cylindrical portion 4b of the heater main body at almost the same locations, and the discharge portion 3c of the vaporizer main body corresponds to the discharge portion 4c of the heater main body at almost the same locations. Moreover, in the heater main body 4, a passage length L near the inlet portion 3a of the vaporizer main body is set to a distance in which a carrier gas (a mist) spreads and flattens (5 cm, for example) in the vaporization passage 5, so that more uniform vaporization can be performed.

Thus, the vaporization passage 5 of a small temperature difference can be formed in such a way that the temperature in the vaporization passage 5 is at a temperature of about 290°C near the inlet portion 3a of the vaporizer main body (nearly equal the passage length L) and at a temperature of about 270°C on the passage after the inlet portion 3a, for example.

Moreover, a second heater may be disposed on the outer periphery on the discharge side of the vaporizer main body 3, for example, in order to eliminate this temperature difference.

Fig. 3 is an illustration of a vaporizer according to another embodiment of the present invention. This is an example in which a second heater 6 is disposed on the outer periphery on the discharge side of a vaporizer main body 3.

In the configuration described above, a carrier gas (a mist) supplied from a pipe connecting unit 2 into a vaporization passage 5 passes through near the outer periphery of a cylindrical portion 4b of a heater main body while being spread at an inlet portion 4a of the heater main body, and the carrier gas is recombined at a discharge portion 4c of the heater main body.

Thus, the passage length of the vaporization passage 5 can be set longer than a length H of the vaporizer main body 3, the dwell time of a carrier gas can be kept longer while implementing the downsizing of the vaporizer main body 3, and sufficient vaporization of the carrier gas can be implemented as well as the effect of direct heating by the heater main body 4.

In the present invention, in forming an STO film, for example, the temperature in the inside of a vaporization chamber was set at a temperature of 250°C for forming a film. The temperature at the coupling of the vaporizer to another device (a film deposition apparatus, for example) was also at a temperature of 250°C. Ripples, particles, and a carbon content of the film were significantly reduced even under the conditions, and in addition to this, a shift of a composition from a desired composition was enabled to be reduced.

### Example

An STO film (a film A) was formed as a shape of a portion (the inlet portion) of the heater on the inlet port side of the vaporizing chamber was formed in a cone.

It is noted that in the example, a cone height/a cone base diameter was set to 0.6.

In the example, the cross sectional area of the passage around the peripheral portion was set the same as the cross sectional area of the passage without the heater.

On the other hand, an STO film (a film B) was similarly formed as the inlet portion of the heater was formed in a cylinder.

In the film A, a shift of SrTiO₃ in stoichiometry was a half of a shift of SrTiO₃ in the film B or less.

Moreover, the number of particles and the carbon content of the film A were a quarter of those of the film B or less.

In the case where the cross sectional area of the passage around the peripheral portion was set in a range of 0.8 to 1.2 of the cross sectional area of the passage without the heater, the effect of the present invention was excellent more than in the case where the cross sectional area of the passage around the peripheral portion was less than 0.8 of the cross sectional area of the passage without the heater and in the case where the cross sectional area of the passage around the peripheral portion was more than 1.2 of the cross sectional area of the passage without the heater.

### INDUSTRIAL APPLICABILITY

According to the present invention, it is possible to provide a vaporizer that can improve the vaporization effect in the inside of the vaporizer and can facilitate temperature management, and it is possible to implement the improvement of the performance of a film deposition apparatus using the vaporizer.

## Claims

1. A vaporizer (1) comprising
a vaporizer main body (3) having an inlet (2) for a carrier gas with film forming liquid (A) and an outlet (3c) for a mist (B);
a heater main body (4) housed within the vaporizer main body (3) such that a passage (5) is formed between the inner surface of the vaporizer main body (3) and the outer surface of the heater main body (4) - in direction of the gasflow - comprising a conical or polygonal pyramid portion, a peripheral portion and a discharge portion, **characterized by** the following feature:
in a cross section in the region of the cone or of the polygonal pyramid the ratio of the cross sectional area (S1) of channel (5) to the cross sectional area (SO) of the inlet port without the cone or polygonal pyramid is between 0.8 and 1.2.

2. The vaporizer according to claim 1, **characterized in that** at the outlet of passage (5) the vaporizer main body (3) and the heater main body (4) also are in the form of conical portions overlapping each other.

3. The vaporizer according to claims 1 or 2, **characterized by** a unit for cooling the inlet portion (4a) for the carrier gas.

4. The vaporizer according to one of claims 1 to 3, **characterized in that** there is provided a second heater on an outer periphery of the discharge portion (3c) of the vaporizer main body.

5. The vaporizer according to one of claims 1 to 4, **characterized in that** the ratio between the height and the base of the conical portion of the heater main body (4) at the entrance of passage (5) is between 0,5 and 1.

## Patentansprüche

1. Verdampfer (1), umfassend:
einen Verdampferhauptkörper (3), der einen Einlass (2) für ein Trägergas mit einer filmbildenden Flüssigkeit (A) und einen Auslass (3c) für einen Nebel (B) aufweist;
einen Heizelementhauptkörper (4), der in dem Verdampferhauptkörper (3) aufgenommen wird, sodass ein Durchlass (5) zwischen der Innenfläche des Verdampferhauptkörpers (3) und der Außenfläche des Heizelementhauptkörpers (4) - in Richtung des Gasstroms - gebildet wird, umfassend einen kegelförmigen Teil oder polygonalen Pyramidenteil, einen peripheren Teil und einen Auslassteil, **gekennzeichnet durch** das folgende Merkmal:
in einem Querschnitt in dem Bereich des Kegels oder der polygonalen Pyramide liegt das Verhältnis der Querschnittsfläche (S1) des Kanals (5) zu der Querschnittsfläche (SO) der Einlassöffnung ohne den Kegel oder die polygonale Pyramide zwischen 0,8 und 1,2.

2. Verdampfer nach Anspruch 1, **dadurch gekennzeichnet, dass** an dem Auslass des Durchlasses (5) der Verdampferhauptkörper (3) und der Heizelementhauptkörper (4) auch in der Form von kegelförmigen Teilen vorliegen, die einander überlappen.

3. Verdampfer nach Anspruch 1 oder 2, **gekennzeichnet durch** eine Einheit zum Abkühlen des Einlassteils (4a) für das Trägergas.

4. Verdampfer nach einem der Ansprüche 1 bis 3, **dadurch gekennzeichnet, dass** ein zweites Heizelement an einem Außenumfang des Auslassteils (3c) des Verdampferhauptkörpers bereitgestellt ist.

5. Verdampfer nach einem der Ansprüche 1 bis 4, **dadurch gekennzeichnet, dass** das Verhältnis zwischen der Höhe und der Basis des kegelförmigen Teils des Heizelementhauptkörpers (4) an dem Eingang des Durchlasses (5) zwischen 0,5 und 1 liegt.

## Revendications

1. Vaporisateur (1) comprenant
un corps principal de vaporisateur (3) ayant une entrée (2) pour un gaz porteur avec un liquide filmogène (A) et une sortie (3c) pour un brouillard (B) ;
un corps principal de dispositif de chauffage (4) logé au sein du corps principal de vaporisateur (3) de sorte qu'un passage (5) est formé entre la surface interne du corps principal de vaporisateur (3) et la surface externe du corps principal de dispositif de chauffage (4) - en direction du flux gazeux - comprenant une portion conique ou de pyramide polygonale, une portion périphérique et une portion d'évacuation, **caractérisé par** la particularité suivante :
en coupe dans la région du cône ou de la pyramide polygonale, le rapport entre l'aire en coupe (S1) du canal (5) et l'aire en coupe (SO) de l'orifice d'entrée sans le cône ou la pyramide polygonale est compris entre 0,8 et 1,2.

2. Vaporisateur selon la revendication 1, **caractérisé en ce qu'**au niveau de la sortie du passage (5), le corps principal de vaporisateur (3) et le corps principal de dispositif de chauffage (4) se présentent également sous la forme de portions coniques qui se chevauchent l'une l'autre.

3. Vaporisateur selon les revendications 1 ou 2, **caractérisé par** une unité pour refroidir la portion d'entrée (4a) pour le gaz porteur.

4. Vaporisateur selon l'une des revendications 1 à 3, **caractérisé en ce qu'**il est prévu un second dispositif de chauffage sur une périphérie externe de la portion d'évacuation (3c) du corps principal de vaporisateur.

5. Vaporisateur selon l'une des revendications 1 à 4, **caractérisé en ce que** le rapport entre la hauteur et la base de la portion conique du corps principal de dispositif de chauffage (4) au niveau de l'entrée du passage (5) est compris entre 0,5 et 1.
